# EUROPÄISCHE PATENTSCHRIFT

(11) **EP 2 095 392 B1**
(45) Veröffentlichungstag und Bekanntmachung des Hinweises auf die Patenterteilung: **01.09.2010**
(21) Anmeldenummer: 07846777.6
(22) Anmeldetag: 23.11.2007
(51) Int. Cl.: H01J 37/32

(54) **VERFAHREN ZUM BETREIBEN EINES PLASMAPROZESSES UND PLASMASYSTEM**
METHOD FOR OPERATING A PLASMA PROCESS AND PLASMA SYSTEM
PROCÉDÉ DE MISE EN OEUVRE D'UN TRAITEMENT PAR PLASMA ET SYSTÈME À PLASMA

(30) Priorität: 23.11.2006 EP 06024306; 24.11.2006 US 867159 P
(43) Veröffentlichungstag der Anmeldung: 02.09.2009
(73) Patentinhaber: Hüttinger Elektronik GmbH & Co. KG, 79111 Freiburg (DE)
(72) Erfinder: NITSCHKE, Moritz, 79114 Freiburg (DE)
(74) Vertreter: Kohler Schmid Möbus
(86) Internationale Anmeldenummer: PCT/EP2007/010176
(87) Internationale Veröffentlichungsnummer: WO 2008/061775

(56) Entgegenhaltungen:
- EP-A- 0 713 242
- DE-C1- 19 651 615
- OCHS, DIRK; RETTICH, THOMAS: "Advanced Power Supplies designed for Plasma Deposition and Etching" VAKUUM IN FORSCHUNG UND PRAXIS, Bd. 18, Nr. 5, 26. September 2006 (2006-09-26), Seiten 32-36, XP002469526

## Beschreibung

Die vorliegende Erfindung betrifft ein Verfahren zum Betreiben eines oder mehrerer Plasmaprozesse, mit zumindest zwei Leistungsversorgungen, sowie ein Plasmasystem zur Durchführung des Verfahrens.

Plasmaprozesse kommen beispielsweise in Plasmabearbeitungs- und Beschichtungsvorrichtungen vor. Es ist eine Vielzahl unterschiedlicher Plasmabearbeitungsvorrichtungen bekannt zum Beispiel PVD, PECVD, Ätzen oder auch die Gaslaseranregung. Eine Form einer solchen Vorrichtung wird aufgrund des zum Einsatz kommenden Sputter-Prozesses verallgemeinernd auch als Sputteranlagen bezeichnet. Insbesondere bei Gleichstrom-Sputteranlagen kommt es oft zu Überschlägen, bei denen sich ein Strom einen elektrisch leitenden Kanal im Plasma sucht. Insbesondere bei dem so genannten reaktiven Beschichten eines Substrats treten derartige Überschläge relativ häufig auf. Ursache hierfür ist der Umstand, dass neben dem Substrat selbst auch Teile der Sputteranlage, wie etwa die Innenwand der Prozesskammer, mit elektrisch nicht oder nur schlecht leitenden Materialien beschichtet werden, die sich dann bis zu einer Durchbruchsspannung aufladen. Um eine größere Beschädigung der Sputteranlagen zu vermeiden, wird deshalb die Stromzufuhr einer Plasma-Gleichspannungsversorgung möglichst schon während des Entstehens eines Überschlags abgeschaltet bzw. kurzzeitig unterbrochen, oder eine Spannung an der Plasmakammer wird kurzgeschlossen oder umgepolt. Um die vorstehend genannten Maßnahmen überhaupt einleiten zu können, sind Vorrichtungen zur Bogenentladungserkennung (Arc-Erkennung) sowie zur Unterdrückung oder Löschung der Bogenentladungen (Arcs) vielfach Bestandteil der Plasma-Stromversorgung oder Plasma-Gleichspannungsversorgung, d.h. der PlasmaLeistungsversorgung.

Wichtig ist dabei in erster Linie die zuverlässige Erkennung von Bogenentladungen oder Arcs. Eine Bogenentladung kann zum Beispiel durch einen Spannungseinbruch bzw. Spannungsabfall oder einen Stromanstieg am Ausgang der Plasma-Gleichspannungsversorgung erkannt werden. Mit anderen Worten: Durch Überwachung wenigstens einer entsprechenden Kenngröße des Plasmaprozesses, wie einer der vorstehend genannten elektrischen Kenngrößen, lässt sich eine Bogenentladungserkennung (Arc-Erkennung) durchführen.

Neben so genannten "hard arcs", die zu Beschädigung der Sputteranlage und zu Defekten bei einem zu bearbeitenden Substrat führen können, sind insbesondere noch so genannte "short arcs" (relativ stark ausgeprägt, jedoch im Gegensatz zu hard arcs selbstverlöschend) und so genannte "micro arcs" (nachfolgend auch als Mikro-Bogenentladungen oder Mikro-Arcs bezeichnet) bekannt. Je nach Einstellung der Schwelle zur Bogenentladungserkennung werden derartige Mikro-Bogenentladungen durch die vorbekannten Verfahren und Vorrichtungen in der Regel gar nicht erkannt, wenn sie von selbst wieder verlöschen. Allerdings ist bekannt, dass derartige Mikro-Bogenentladungen sich verstärken und anschließend zu einem schwerwiegenderen short arc oder hard arc führen können.

Um dem vorzubeugen ist es z.B. aus der EP 0 692 138 B1 bekannt, die Spannungsversorgung periodisch für eine vorgebbare kurze Zeit umzupolen, um Aufladungen in der Plasmakammer zu entladen. Man spricht in diesem Zusammenhang auch von DC-Pulsbetrieb. Gegenüber einem kontinuierlichen Plasmaprozess ist das Arcen damit oftmals deutlich reduziert, die Beschichtungs- bzw. Abtragungsrate reduziert sich jedoch ebenfalls.

Der Arikel "Advanced Power Supplies designed for Plasma Deposition and Etching" von D. Ochs und T. Rettich, erschienen in Vakuum in Forschung und Praxis 18 (2006) Nr. 5, beschreibt DC-Leistungsversorgungen zum Betreiben von Plasmaprozessen, von denen bis zu vier Module nach dem Master-Slave-Prinzip zusammengeschaltet und über einen Feldbus (DeviceNet oder Profibus) von einer externen Kontrolleinrichtung angesteuert werden können. Jedes Modul verfügt über eine eigene Arc-Management-Einheit, die ein intelligentes Arc-Managment mit Arc-Erkennungszeiten von 1 µs ermöglicht.

Der Erfindung liegt die Aufgabe zugrunde, ein Verfahren und ein System bereitzustellen, mit denen gleichmäßige Plasmaprozessbedingungen bei hohen Beschichtungs- oder Ätzraten realisiert werden können.

Die Aufgabe wird durch ein Verfahren nach Anspruch 1 und ein Plasmasystem nach Anspruch 11 zur Durchführung dieses Verfahrens gelöst.

In einem ersten Aspekt betrifft die Erfindung ein Verfahren zum Betreiben eines oder mehrerer Plasmaprozesse in einer Plasmakammer, mit zumindest zwei Leistungsversorgungen mit den Verfahrensschritten:
a. Durchführen einer Arcerkennung für zumindest eine der Leistungsversorgungen;
b. Erzeugen zumindest eines mit der Arcerkennung in Beziehung stehenden Signals und/oder von mit der Arcerkennung in Beziehung stehenden Daten;
c. Übermitteln des zumindest einen Signals und/oder der Daten an eine Plasmaprozessregelungseinrichtung und/oder an eine oder mehrere andere Leistungsversorgungen und/oder an eine oder mehrere den anderen Leistungsversorgungen zugeordneten Arcableitervorrichtungen.

Mit diesem Verfahren können mehrere Leistungsversorgungen miteinander synchronisiert werden und/oder in die Gesamtregelung eines Plasmaprozesses einbezogen werden. Beispielsweise können die Aus-Zeiten oder Umpol-Zeiten der einzelnen Leistungsversorgungen aufeinander abgestimmt werden, so dass nicht an einer Stelle des Plasmaprozesses die Leistungszufuhr sehr häufig unterbrochen wird, während an einer anderen Stelle die Leistungszufuhr nur geringfügig unterbrochen wird. Insbesondere können die Leistungsversorgungen miteinander kommunizieren und die jeweiligen durchzuführenden Gegenmaßnahmen, die die Entwicklung von "short arcs" oder "hard arcs" verhindern sollen, abstimmen. Ein mit der Arcerkennung in Beziehung stehendes Signal ist beispielsweise ein Signal, das eine Gegenmaßnahme auslöst oder ein Arcerkennungssignal. Es kann jedoch auch ein Signal sein, welches anzeigt, dass eine Gegenmaßnahme bereits durchgeführt wurde. Außerdem kann es ein Signal sein, das anzeigt, dass eine bestimmte Anzahl von Arcs oder Art von Arcs, z.B. Mikro-Arcs, aufgetreten ist. Mit der Arcerkennung in Beziehung stehende Daten können unter anderem die Anzahl und/oder Dauer von Gegenmaßnahmen, die Blockierzeit, die verstreicht, ehe eine Gegenmaßnahme durchgeführt wird, oder die Häufigkeit des Auftretens von Arcs oder Art von Arcs, z.B. Mikro-Arcs sein. Signale oder Daten, die mit einer Gegenmaßnahme in Verbindung stehen, sind im Sinne der Erfindung demnach auch Signale bzw. Daten, die mit einer Arcerkennung in Beziehung stehen.

Wenn in dieser Beschreibung von "Arcs" die Rede ist, sind sämtliche Arten von Arcs umfasst. Besondere Vorteile der Erfindung ergeben sich jedoch, wenn sie auf Mikro-Arcs angewandt wird.

Wenn nur für eine Leistungsversorgung eine Arcerkennung vorhanden ist, wobei die Arc-Erkennung in der Leistungsversorgung oder getrennt davon realisiert sein kann, so kann von der einen Leistungsversorgung ein entsprechendes Signal an die anderen Leistungsversorgungen übertragen werden, so dass alle Leistungsversorgungen gleichzeitig eine, vorzugsweise dieselbe, Gegenmaßnahme durchführen können. In diesem Fall wird eine Leistungsversorgung als Master und die anderen Leistungsversorgungen als Slave betrieben.

Es kann für jede Leistungsversorgung eine Arcerkennung durchgeführt werden und ein mit der Arcerkennung in Beziehung stehendes Signal oder mit der Arcerkennung in Beziehung stehende Daten erzeugt werden. Dadurch können Informationen über den Plasmaprozess an den Stellen der jeweiligen Leistungsversorgungen bereitgestellt werden.

Das für eine Leistungsversorgung erzeugte mit der Arcerkennung in Beziehung stehende Signal und/oder die erzeugten mit der Arcerkennung in Beziehung stehende Daten können den jeweils anderen Leistungsversorgungen und/oder der Plasmaprozessregelungseinrichtung übergeben werden. Die anderen Leistungsversorgungen können unter Berücksichtigung dieser Signale und/oder Daten entsprechende Maßnahmen einleiten oder Algorithmen ausführen, so dass ein homogener Plasmaprozess aufrechterhalten wird. Alternativ oder zusätzlich kann eine Plasmaprozessregelungseinrichtung unter Berücksichtigung der Signale und/oder Daten den Plasmaprozess so regeln, dass eine homogene Beschichtung oder ein homogenes, gleichmäßiges Ätzen erfolgt.

Eine Gegenmaßnahme kann als Reaktion auf das Erkennen eines oder mehrerer Arcs eingeleitet werden. Unter anderem kann die weitere Leistungszufuhr in einen Arc unterbunden werden. Bei Erkennen eines Mikro-Arcs kann ein kurzzeitiges Umpolen als Gegenmaßnahme erfolgen, um das Entstehen eines "hard arcs" zu vermeiden.

Als mit der Arcerkennung in Beziehung stehende Daten werden erfindungsgemäß Informationen über durchgeführte Gegenmaßnahmen übermittelt. Die Daten können Informationen über die Anzahl und/oder Dauer von Umpolungen oder Aus-Zeiten der Leistungsversorgung und/oder Informationen über die von der Leistungsversorgung erzeugte Energie umfassen.

Weiter wird erfindungsgemäß für zumindest eine Leistungsversorgung überprüft, ob eine geringere Anzahl oder Dauer von Gegenmaßnahmen als bei anderen Leistungsversorgungen durchgeführt wurde und bei Unterschreiten einer vorgegebenen Dauer oder Anzahl werden Maßnahmen zur Erhöhung der Dauer oder Anzahl durchgeführt. Dies kann bedeuten, dass der Schwellwert, mit dem eine Kenngröße zur Arcerkennung verglichen wird, empfindlicher eingestellt wird. Zudem kann ein gezieltes periodisches oder aperiodisches Pulsen durchgeführt werden. Weiterhin ist es denkbar, dass für die Arcerkennung weitere Kenngrößen, die zu einer noch empfindlicheren Erkennung von Arcs oder Mikro-Arcs führen, herangezogen werden. Weiterhin kann die Dauer der durchgeführten Gegenmaßnahmen, beispielsweise die Umpolungsdauer, verlängert werden. Außerdem kann eine Blockierzeit, die abgewartet wird, ehe eine Gegenmaßnahme eingeleitet wird, verändert werden. Diese Maßnahmen können dazu führen, dass die Aus - Zeiten beziehungsweise Umpolzeiten der Leistungsversorgungen aneinander angeglichen werden. Dadurch erfolgt eine gleichmäßigere Beschichtung oder ein gleichmäßigeres Ätzen.

Außerdem ist es denkbar, dass die Leistung des Gesamtprozesses reduziert wird. Weiterhin könnte eine Geschwindigkeitsregelung, mit der ein Substrat durch den Plasmaprozess geschleust wird, oder die Verweildauer im Plasmaprozess verändert werden.

Wie bereits erwähnt, kann bei Erkennen eines Arcs oder Mikro-Arcs für eine Leistungsversorgung bei dieser und der/den anderen Leitungsversorgungen eine Gegenmaßnahme ausgelöst wird. Das Auslösen der Gegenmaßnahmen wird dadurch synchronisiert.

Weiterhin ist es denkbar, dass das mit der Arcerkennung in Beziehung stehende Signal erst ausgegeben wird, wenn eine Gegenmaßnahme durchgeführt wird und die anderen Leistungsversorgungen daraufhin ebenfalls eine Gegenmaßnahme durchführen. Die anderen Leistungsversorgungen können dieses Signal erkennen und entsprechend eigener Algorithmen darauf reagieren. Ein möglicher Algorithmus wäre, dass nach abgelaufener eigener Blockierzeit ebenfalls ein Umpolen erfolgt. Weiterhin könnte bei nicht abgelaufener eigener Blockierzeit, also wenn das Signal zu einem Zeitpunkt ankommt, wenn die eigene Blockierzeit läuft, unmittelbar nach Ablauf der Blockierzeit mit einem Umpolen reagiert wird.

Eine besonders einfache Synchronisation und Homogenisierung des Plasmaprozesses kann erfolgen, wenn eine Leistungsversorgung als Master und eine oder mehrere andere Leistungsversorgungen als Slave betrieben werden.

Der oder die in der Plasmakammer stattfindenden Plasmaprozesse führen zu einer Plasmabearbeitung, beispielsweise eines Substrats oder eines Werkstücks. Wenn unterschiedliche Leistungsversorgungen unterschiedlich auf Arcs reagieren, können sich die Plasmaprozesse unterscheiden, beispielsweise, indem sie unterschiedliche Sputterraten haben, so dass die Plasmabearbeitung ungleichmäßig wird. Um dem entgegenzuwirken kann eine die Homogenität der Plasmabearbeitung begünstigende Maßnahme eingeleitet oder durchgeführt werden. Eine solche Maßnahme kann aufgrund der mit der Arcerkennung in Beziehung stehenden Signale und/oder Daten eingeleitet oder durchgeführt werden.

Die die Homogenität der Plasmabearbeitung begünstigenden Maßnahmen können umfassen:
- Einstellen der Arcerkennungsschwelle (Schwellwert, mit dem eine Kenngröße verglichen wird) für eine oder mehrere Leistungsversorgungen;
- gezieltes periodisches oder aperiodisches Pulsen einer oder mehrerer Leistungsversorgungen;
- gezieltes Pulsen für einen eingeschränkten Zeitbereich, so genannte Pulsbursts;
- Hinzuziehen weiterer Kenngrößen zur Arcerkennung;
- Einstellung der Umpolspannung oder -dauer oder Aus-Zeit für eine oder mehrere Leistungsversorgungen;
- Verändern einer Blockierzeit;
- Verringerung der Gesamtleistung des Systems;
- Steuern der Leistung einzelner Leistungsversorgungen;
- Regeln der Vorschubgeschwindigkeit und/oder der Verweildauer der Substrate in der Plasmakammer.

Diese Aufzählung gibt nur beispielhafte mögliche Maßnahmen an. Selbstverständlich sind weitere Maßnahmen denkbar und von der vorliegenden Erfindung ebenfalls umfasst.

Wenn die Gegenmaßnahmen zumindest zweier Leistungsversorgungen synchronisiert werden, liefert dieser einen Beitrag zur Homogenisierung des Plasmaprozesses.

Wenn zumindest eine der Leistungsversorgungen gepulst betrieben wird, kann das Auftreten von Arcs reduziert werden. Um eine hohe Abscheidrate zu erzielen, kann eine Leistungsversorgung mit einer relativ geringen Pulsrate gepulst werden, so dass während eines möglichst großen Zeitraums Leistung in den Plasmaprozess geliefert wird. Wenn eine weitere Leistungsversorgung mit der Mikro-Arc-Detection Technologie (s.u.) betrieben wird, kann die Abscheidrate optimiert werden.

Die Arcerkennung kann beispielsweise folgendermaßen erfolgen: Überwachen wenigstens einer ersten Kenngröße (KG) des Plasmaprozesses, indem die wenigstens eine erste Kenngröße mit einem vorgebbaren ersten Schwellwert verglichen und bei Erreichen des ersten Schwellwerts eine potenzielle Bogenentladung erkannt und eine erste Gegenmaßnahme zur Bogenentladungsunterdrückung ausgelöst wird, wobei die wenigstens eine erste Kenngröße und/oder wenigstens eine zweite Kenngröße mit einem vorgebbaren zweiten Schwellwert verglichen wird, der von dem ersten Schwellwert verschieden ist, und bei Erreichen des zweiten Schwellwerts eine zweite Gegenmaßnahme zur Bogenentladungsunterdrückung ausgelöst wird, und dass nach erfolgtem Auslösen der zweiten Gegenmaßnahme während einer Blockierzeit ein erneutes Auslösen der zweiten Gegenmaßnahme unterbunden wird.

In einem weiteren Aspekt betrifft die Erfindung ein Plasmasystem zur Durchführung des erfindungsgemäßen Verfahrens mit zumindest zwei Leistungsversorgungen, einer Plasmakammer, einer Prozessregelungseinrichtung und zumindest einer Arcerkennungseinrichtung, die einer der Leistungsversorgungen zugeordnet ist, wobei die Leistungsversorgungen signaltechnisch und/oder datentechnisch miteinander und/oder mit der Prozessregelungseinrichtung verbunden sind. Die Leistungsversorgungen weisen eine Arcschnittstelleneinheit auf, in der als mit der Arcerkennung in Beziehung stehende Daten Informationen über durchgeführte Gegenmaßnahmen generiert und von dieser ausgegeben werden.

In der Anmeldung WO 2008/061784 wird eine Plasmaleistungsversorgung beschrieben, die eine Arcschnittstelleneinrichtung (Arc Interface Unit) aufweist, mit Hilfe derer man schnell und direkt auf eine Arcableiter-Steuerung oder einen Arcableiter (arc diverter) einwirken kann.

Die Leistungsversorgungen können eine Eingangsvorrichtung, insbesondere umfassend einen Arc-Eingang, der als Mikro-Arc-Eingang ausgebildet sein kann, und/oder eine Ausgangsvorrichtung, insbesondere umfassend einen Arc-Ausgang, der als Mikro-Arc-Ausgang ausgebildet sein kann, aufweisen. Wird für eine Leistungsversorgung ein Arc erkannt, so kann ein Arcerkennungs-Signal auf den Ausgang dieser Leistungsversorgung gelegt und an die Arc-Eingänge der anderen Leistungsversorgungen gegeben werden. Die Arc-Erkennung wirkt nun für alle Stromversorgungen wie die eigene Erkennung eines Arcs. Wenn die vorgebbare Blockierzeit abgelaufen ist, wird auf diese Arc-Erkennung mit einer Gegenmaßnahme reagiert. Wenn die Arcerkennung nicht in den Leistungsversorgungen selbst realisert ist, können Signale externer Arcerkennungseinrichtungen auf den Arc-Eingang gegeben werden, und zwar sowohl ein Signal der einer Leistungsversorgung zugeordneten Arcerkennungseinrichtung als auch Signale von Arcerkennugseinrichtungen, die anderen Leistungsversorgungen zugeordnet sind.

Ein Tor (Port) der Leistungsversorgungen kann als Eingangs- und Ausgangsvorrichtung, insbesondere Eingangs- und Ausgangstor, ausgebildet sein. Die schließt die Möglichkeit ein, dass das Ein-/Ausgangstor als Open-Kollektoranschluss ausgebildet ist und die Open-Kollektoranschlüsse der Leistungsversorgungen miteinander verbunden sind. Die Spannung an diesem Aus-/Eingang kann mit einem Widerstand auf hohem Potential gehalten werden, z.B. mit 100 kΩ auf 5 Volt. Ein elektronischer Schalter, z.B. ein Transistor, kann diesen Port auf Masse kurzschließen. Viele Ports dieser Bauart (nämlich verschiedener Leistungsversorgungen) können über ein Kabel zusammengeschaltet werden. Wenn nur ein einziger der Schalter, ein Schalter nur einer Leistungsversorgung, den Port kurzschließt, so ist an allen Ports unmittelbar eine Spannungsänderung von hohem Potential (5V) zu niedrigem Potential (nahe 0V) messbar. Auf diese Weise können Leistungsversorgungen mit einem Arc-In-/Output-Port zusammengeschaltet werden. Die jeweils eigene Arc-Erkennung wirkt auf die Schalter so, dass sie den Arc-In-/Output-Port auf nahe 0V legen. Die Überwachung des Ports ist dann die eigentliche Arc-Erkennung.

Die Dauer der Austastung kann über einen solchen Port durch die Dauer des Pulse der Signaländerung am Port signalisiert werden. Auf diese Weise können die Stromversorgungen noch besser synchronisiert werden.

Auf einen solchen Port können auch externe Signale gelegt werden, im Extremfall sogar ein periodisches Pulssignal. In diesem Fall würde man aber die gegenüber dem periodischen Pulsen verbesserte Funktionalität der Micro-Arc-Detection-Technologie nicht ausnutzen.

Die Arc-Erkennung kann eine Mikro-Arc-Erkennung sein. Die Micro-Arc-Erkennung zeigt sich durch die Erkennung und ggf. Einleitung von Gegenmaßnahmen bei sehr geringen Arc-Energien aus. Bisher wurde auf solche Micro-Arcs in der Regel überhaupt nicht reagiert, oftmals wurden sie nicht erkannt. Wenn nun auf solche Micro-Arcs reagiert wird, um den Plasmaprozess zu stabilisieren, so ist die Synchronisierung extrem wichtig.

Eine Ausgestaltung kann die so genannte Multi-Level-Arc-Detection-Technologie (auch bezeichnet als Mikro-Arc-Detection-Technologie) sein. Sie ist z.B. aus den Anmeldungen WO 2008/061680 oder EP 06024306 bekannt. Hier wird eine Technologie beschrieben, bei der anstatt periodisch zu pulsen, nur bei Erkennen von so genannten Micro-Arcs eine Gegenmaßnahme eingeleitet wird, z.B. die Spannung für eine vorgebbare kurze Zeit umgepolt wird, und im Anschluss an eine solche Gegenmaßnahme für eine vorgebbare Blockierzeit eine erneute Gegenmaßmahme auch bei erneutem Erkennen eines Micro-Arcs unterdrückt wird. Auf diese Weise lässt sich eine sehr viel höhere Beschichtungs- bzw. Abtragungsrate als beim periodischen Pulsen erzielen. Außerdem lässt sich der Grad der Verschmutzung anhand der Pulswiederholfrequenz ablesen. Die Pulswiederholfrequenz entspricht der Häufigkeit der durchgeführten Gegenmaßnahmen.

In Plasmaprozessen, in denen bisher mehrere periodisch gepulste Leistungsversorgungen unabhängig voneinander eingesetzt wurden, kann nicht ohne weiteres die neue Mikro-Arc-Detection-Technologie als Ersatz für das periodische Pulsen (d.h. periodische Ausschalten der Leistungsversorgung oder Unterbinden der Leistungsversorgung zu einem Plasmaprozess) eingesetzt werden. Das hängt mit der Unvorhersagbarkeit der Micro-Arcs zusammen. Wenn z.B. zwei Plasmaprozesse von je einer periodisch gepulsten Leistungsversorgung gespeist werden, die jeweils mit der gleichen Frequenz und der jeweils gleichen Umpolungsdauer eingestellt werden, so erzielt man mit diesen beiden Leistungsversorgungen ein gemeinsames weitestgehend vorhersagbares Beschichtungsergebnis. Würde man das gleiche mit zwei Leistungsversorgungen mit der Micro-Arc-Detection-Technologie versuchen, so würden nur zufällig beide Leistungsversorgungen und damit beide Plasmaprozesse mit der gleichen Pulsrate arbeiten. Im Extremfall arbeitet die eine Leistungsversorgung mit einer sehr hohen Pulsrate und die andere im nahezu kontinuierlichen Betrieb. Das kann zu unvorhersagbaren und eventuell unerwünschten Ergebnissen in der Beschichtungsrate führen. Die beschriebene Synchronisation kann dem positiv entgegenwirken.

Jeder Leistungsversorgung kann ein Arcableiter zugeordnet sein. Der Arcableiter kann zur Durchführung unterschiedliche Gegenmaßnahmen bei Erkennen eines Arcs oder Mikro-Arcs ausgebildet sein. Er kann ein Umpolen der Leistungsversorgung oder ein Ausschalten einer Leistungsversorgung bewirken.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigen, sowie aus den Ansprüchen. Die einzelnen Merkmale können je einzeln für sich oder zu mehreren in beliebiger Kombination bei einer Variante der Erfindung verwirklicht sein.

Bevorzugte Ausführungsbeispiele der Erfindung sind in der Zeichnung schematisch dargestellt und werden nachfolgend mit Bezug zu den Figuren der Zeichnung näher erläutert. Es zeigt:
- **Fig. 1**: eine schematische Darstellung eines Plasmasystems;
- **Fig. 2**: eine schematische Darstellung einer Arcschnittstelleneinrichtung;
- **Fig. 3**: ein Flussdiagramm zur Darstellung einer ersten Verfahrensvariante;
- **Fig. 4**: ein Flussdiagramm zur Darstellung einer zweiten Verfahrensvariante;
- **Fig. 5**: ein Flussdiagramm zur Darstellung einer dritten Verfahrensvariante.

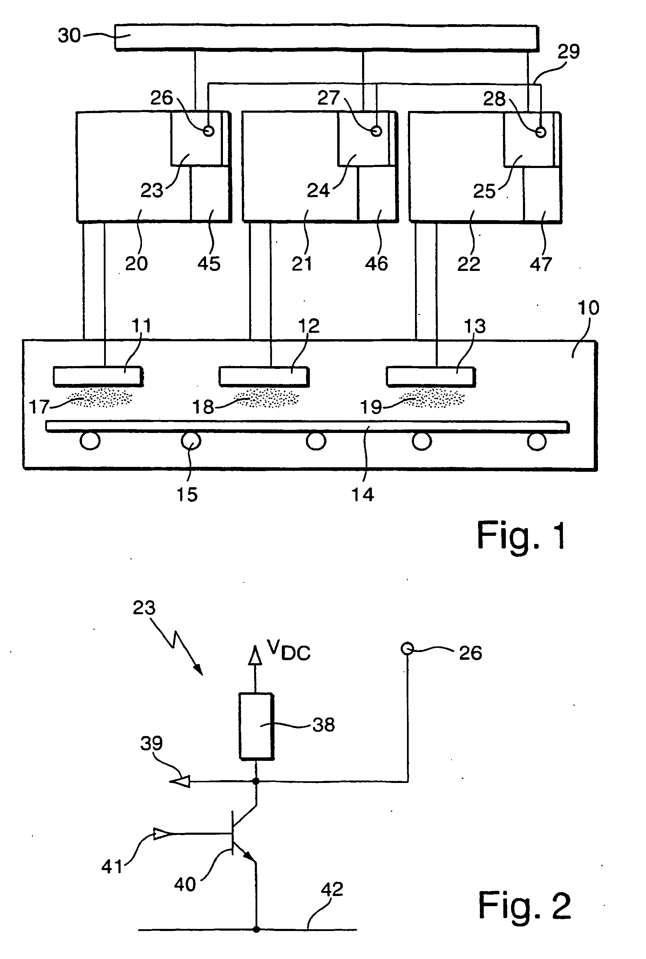

In Figur 1 ist eine Plasmakammer 10 mit drei Elektroden 11, 12, 13 gezeigt. Durch die Plasmakammer 10 wird ein Substrat 14 auf Rollen 15 durchgeführt und möglichst vorhersagbar gleichmäßig von allen Elektroden 11 - 13 beschichtet. Die Leistungsversorgung 20 versorgt die Elektrode 11 mit Leistung und erzeugt demzufolge ein Plasma in der Umgebung der Elektrode 11. Das gleiche macht die Leistungsversorgung 21 mit der Elektrode 12 und die Leistungsversorgung 22 mit der Elektrode 13. Somit werden in der Plasmakammer 10 drei Plasmaprozesse 17, 18, 19 betrieben, die zu einer Plasmabearbeitung des Substrats 14 führen.

Jede Leistungsversorgung umfasst eine Arcschnittstelleneinrichtung 23, 24, 25 mit einer Eingabe-/Ausgabe- (IN/OUT) Vorrichtung 26 - 28. Diese Vorrichtungen 26 - 28 können jeweils in einem elektrischen Anschluss realisiert sein, es können aber auch mehrere Anschlüsse sein.

Für den Fall, dass es nur ein Anschluss ist, kann eine Vorrichtung gemäß Figur 2 genutzt werden.

Die Leistungsversorgungen 20 - 22, insbesondere die Arcschnittstelleneinrichtungen 23 - 25, sind über eine Daten - und/oder Signalleitung 29 miteinander verbunden, so dass Signale und/oder Daten ausgetauscht werden können. Diese Daten können von den einzelnen Leistungsversorgungen 20 - 22 berücksichtigt werden, um eine möglichst gleichmäßige Beschichtung realisieren zu können. Die Daten - und/oder Signalleitung 29 kann als Datenbus ausgebildet sein.

Weiterhin können die Leistungsversorgungen 20 - 23 mit einer Plasmaprozessregelungseinrichtung 30 datentechnisch verbunden sein. Der Plasmaprozessregelungseinrichtung 30 werden Daten, die mit der Arcerkennung in Beziehung stehen, übermittelt. Diese kann dann den Gesamtprozess so regeln, dass eine möglichst gleichmäßige Bearbeitung des Substrats 14 erfolgt.

Die Leistungsversorgung 20 kann als Master ausgebildet sein, so dass bei einer Arcerkennung durch die Leistungsversorgung 20, beispielsweise wenn eine überwachte Kenngröße einen Schwellenwert erreicht, Gegenmaßnahmen durch alle Leistungsversorgungen 20-22 durchgeführt werden. Die Leistungsversorgungen 21,22 werden in diesem Fall als Slave betrieben. Dies bedeutet, dass in diesen Leistungsversorgungen 21,22 entweder keine Arcerkennung durchgeführt wird oder eine dort durchgeführte Arcerkennung keine Auswirkungen auf die anderen Leistungsversorgungen entfalten kann.

In einer alternativen Ausgestaltung kann beispielsweise die Leistungsversorgung 20 eine Arcerkennung durchführen, indem eine erste Kenngröße mit einem ersten Schwellenwert verglichen wird und die Leistungsversorgung 21 kann eine Arcerkennung durchführen, indem eine zweite Kenngröße mit einem zweiten Schwellenwert verglichen wird. Die Arcerkennung der beiden Leistungsversorgungen 20,21, und insbesondere dadurch ausgelöste Gegenmaßnahmen können synchronisiert werden. Diese Vorgehensweise ist auch auf drei oder mehr Leistungsversorgungen 20 - 22 erweiterbar.

In der Figur 2 ist eine Arcschnittstelleneinrichtung 23 im Detail gezeigt. Die Spannung an der Eingabe-/Ausgabe-Vorrichtung 26, die hier ein einziger elektrischer Anschluss ist, wird zum einen überwacht, was durch die Bezugsziffer 39 angedeutet ist. Zum anderen wird die Spannung an der Eingabe-/Ausgabe-Vorrichtung 26 über einen relativ hochohmigen Widerstand 38 (1-1000kΩ) auf ein Potential V_{DC} gebracht. Ein Ansteuersignal 41 steuert einen elektronischen Schalter 40, hier einen Bipolar-Transistor, an. Bei inaktiver Ansteuerung verhält sich der Transistor hochohmig (noch hochohmiger als der Widerstand) und die Spannung an der Eingabe-/Ausgabe-Vorrichtung 26 liegt näherungsweise auf dem Potential V_{DC}. Bei aktiver Ansteuerung verhält sich der Transistor niederohmig (deutlich niederohmiger als der Widerstand) und die Spannung an der Eingabe-/Ausgabe-Vorrichtung 26 liegt näherungsweise auf dem Masse-Potential 42. Diese Spannungsänderung wird bei 39 gemessen. Werden mehrere solcher Eingabe-/Ausgabe-Vorrichtungen 26 von jeweils unterschiedlichen Leistungsversorgungen zusammengeschaltet, so erkennt jede Leistungsversorgung, wenn eine der Leistungsversorgungen diese Eingabe-/Ausgabe-Vorrichtung 26 auf Masse-Potential 42 zieht, dass eine der Leistungsversorgungen einen Arc erkannt hat. Somit erhalten alle Leistungsversorgungen ein Arcerkennungssignal.

Je nachdem, wie ein Arcableiter 45 - 47 (Fig. 1) konfiguriert ist, kann in diesem Fall sofort eine Gegenmaßnahme eingeleitet werden oder erst eine Blockierzeit abgewartet werden und anschließend eine Gegenmaßnahme eingeleitet werden. Dadurch, dass die Leistungsversorgungen 20-22 über die Daten - und/oder Signalleitung 29 miteinander verbunden sind, können diese Maßnahmen synchronisiert ausgeführt werden, da alle Leistungsversorgungen 20 - 22 nahezu zeitgleich das Arcerkennungssignal erhalten. In der Fig. 1 sind die Arcableiter 45 - 47 als Bestandteil der Leistungsversorgungen 20 - 22 gezeigt. Dies ist nicht zwingend. Sie können auch als separate Einrichtungen vorgesehen sein, die den Leistungsversorgungen 20 - 22 lediglich zugeordnet sind.

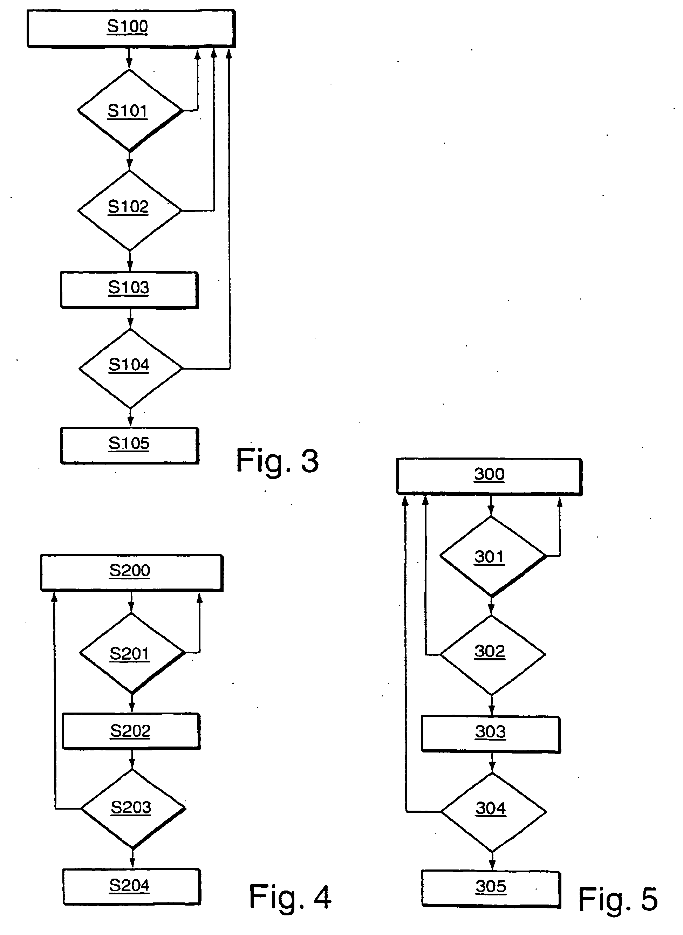

Die Fig. 3 zeigt ein Flussdiagramm zur Darstellung einer ersten Verfahrensvariante. In einem ersten Schritt S100 führt eine Leistungsversorgung oder eine der Leistungsversorgung zugeordnete Arcerkennungseinrichtung eine Mikro-Arcerkennung durch, beispielsweise indem eine oder mehrere Kenngrößen des Plasmaprozesses mit einem oder mehreren Schwellenwerten verglichen werden. Wird im Schritt S101 erkannt, dass ein Mikro-Arc vorliegt, wird im Schritt S102 überprüft, ob eine vorgegebene Blockierzeit, während der keine Gegenmaßnahme eingeleitet werden darf, abgelaufen ist. Bejahendenfalls wird eine Gegenmaßnahme im Schritt S103 eingeleitet und werden Daten, die mit der Arcerkennung in Beziehung stehen, erfindungsgemäß die Dauer oder Häufigkeit der Gegenmaßnahmen, ausgegeben. Im Schritt S104 wird ein Vergleich mit der Dauer oder Häufigkeit der Gegenmaßnahmen bei anderen Leistungsversorgungen durchgeführt. Wird erkannt, dass die Gegenmaßnahmen der anderen Leistungsversorgungen länger oder häufiger sind, wird im Schritt S105 eine die Homogenität der Plasmabearbeitung begünstigende Maßnahme durchgeführt. Das Verfahren der Fig. 3 wird für mehrere Leistungsversorgungen durchgeführt. Ergeben die Abfragen in den Schritten S101, S102 und S104 ein negatives Ergebnis, wird jeweils zum Schritt S100 übergegangen.

Mit anderen Worten erfolgt eine Synchronisierung der Leistungsversorgungen wie folgt:

Es erfolgt ein Austausch der Anzahl und Dauer von Umpolungen oder Austausch der Aus-Zeiten. Liegt eine der Leistungsversorgungs-Auszeiten um einen vorgebbaren Wert unterhalb der anderen, so werden Gegenmaßnahmen getroffen, die zu einer höheren Auszeit führen, z.B. wird der Mikro-Arc-Schwellwert empfindlicher gestellt. Alternativ oder zusätzlich kann ein gezieltes periodisches oder aperiodisches Pulsen der Leistungsversorgung erfolgen. Andere Kenngrößen können hinzugezogen werden, um zu einer noch empfindlicheren Erkennung von Mikro-Arcs zu kommen. Die Umpoldauer kann verändert, insbesondere verlängert werden. Die Blockierzeit kann verändert werden. Weiterhin kann die Leistung verringert werden. In die Gesamtsteuerung des Plasmaprozesses könnte die Geschwindigkeitsregelung, mit der ein Substrat durch den Plasmaprozess geschleust wird, mit einbezogen werden.

Die Fig. 4 zeigt ein Flussdiagramm zur Darstellung einer Verfahrensvariante, die Verfahrensschritte für eine Weiterbildung des erfindungsgemäßen Verfahrens enthält. In einem ersten Schritt S200 führt eine Leistungsversorgung oder eine der Leistungsversorgung zugeordnete Arcerkennungseinrichtung eine Mikro-Arcerkennung durch, beispielsweise indem eine oder mehrere Kenngrößen des Plasmaprozesses mit einem oder mehreren Schwellenwerten verglichen werden. Wird im Schritt S201 erkannt, dass ein Mikro-Arc vorliegt oder dass ein Arcerkennungssignal einer anderen Leistungsversorgung empfangen wurde, wird im Schritt S202 ein Arcerkennungssignal geändert bzw. an die anderen Leistungsversorgungen übergeben. Gegebenenfalls kann eine Unterscheidung vorgenommen werden, ob es sich um eine eigene Arcerkennung handelt oder ob ein Arcerkennungssignal einer anderen Leistungsversorgung vorliegt. In letzterem Fall kann der Schritt S202 übersprungen werden und direkt von S201 nach S203 gegangen werden. Im Schritt S203 wird überprüft, ob eine vorgegebene Blockierzeit, während der keine Gegenmaßnahme eingeleitet werden darf, abgelaufen ist. Bejahendenfalls wird im Schritt S204 eine Gegenmaßnahme eingeleitet. Im Schritt S205 wird überprüft, ob ein Arcerkennugssignal einer anderen Leistungsversorgung empfangen wurde. Bejahendenfalls erfolgt ein Sprung nach Schritt S203 und wird geprüft, ob eine Blockierzeit abgelaufen ist. Ergeben die Abfragen in den Schritten S201 und S203 ein negatives Ergebnis, wird jeweils zum Schritt S200 übergegangen.

Diese Verfahrenvariante lässt sich auch wie folgt schildern:

Bei Erkennen eines Mikro-Arcs wird ein Mikro-Arc-Detection-Signal am Ausgang der Leistungsversorgung angezeigt. Dieser Ausgang wird auf einen Eingang der anderen Leistungsversorgungen gelegt. Die Mikro-Arc-Erkennung wirkt nun für alle Leistungsversorgungen wie die eigene Erkennung eines Mikro-Arcs. Wenn die vorgebbare Blockierzeit abgelaufen ist, wird auf diese Mikro-Arc-Erkennung mit einer ersten Gegenmaßnahme reagiert.

Die Fig. 5 zeigt ein Flussdiagramm zur Darstellung einer Verfahrensvariante, die Verfahrensschritte für eine Weiterbildung des erfindungsgemäßen Verfahrens enthält. In einem ersten Schritt S300 führt eine Leistungsversorgung oder eine der Leistungsversorgung zugeordnete Arcerkennungseinrichtung eine Mikro-Arcerkennung durch, beispielsweise indem eine oder mehrere Kenngrößen des Plasmaprozesses mit einem oder mehreren Schwellenwerten verglichen werden. Wird im Schritt S301 erkannt, dass ein Mikro-Arc vorliegt oder ein Arcerkennungssignal einer anderen Leistungsversorgung empfangen wurde, wird im Schritt S302 überprüft, ob eine vorgegebene Blockierzeit, während der keine Gegenmaßnahme eingeleitet werden darf, abgelaufen ist. Bejahendenfalls wird im Schritt S303 eine Gegenmaßnahme eingeleitet. Im Schritt S304 wird überprüft, ob die Gegenmaßnahme aufgrund einer eigenen Arcerkennung erfolgte. Bejahendenfalls wird ein Arcerkennungssignal im Schritt S305 geändert bzw. an die anderen Leistungsversorgungen übergeben. Ergeben die Abfragen in den Schritten S301, S302 und S304 ein negatives Ergebnis, wird jeweils zum Schritt S300 übergegangen.

Im Vergleich zur Verfahrensvariante gemäß Fig. 4 bedeutet dies, dass anstatt bei Mikro-Arc-Erkennung ein Signal auszugeben, auch 'nur' oder 'erst' bei Auslösen der Gegenmaßnahme (z.B. Umpolen) ein Signal ausgegeben und dieses Signal den anderen Leistungsversorgungen zugeführt werden kann. Die anderen Leistungsversorgungen erkennen dieses Signal und reagieren entsprechend eigener Algorithmen darauf. Ein möglicher Algorithmus wäre beispielsweise: Bei abgelaufener eigener Blockierzeit erfolgt ebenfalls ein Umpolen. Bei nicht abgelaufener Blockierzeit wird unmittelbar nach Ablauf der Blockierzeit mit Umpolen reagiert.

## Patentansprüche

1. Verfahren zum Betreiben eines oder mehrerer Plasmaprozesse in einer Plasmakammer, mit zumindest zwei Leistungsversorgungen mit den Verfahrensschritten:
a. Durchführen einer Arcerkennung für zumindest eine der Leistungsversorgungen;
b. Erzeugen zumindest eines mit der Arcerkennung in Beziehung stehenden Signals und/oder von mit Arcerkennung in Beziehung stehenden Daten;
c. Übermitteln des zumindest einen Signals und/oder der Daten an eine Plasmaprozessregelungseinrichtung und/oder an eine oder mehrere andere Leistungsversorgungen oder an eine oder mehrere den anderen Leistungsversorgungen zugeordneten Arcableitervorrichtungen,
**dadurch gekennzeichnet, dass** als mit der Arcerkennung in Beziehung stehende Daten Informationen über durchgeführte Gegenmaßnahme übermittelt werden, wobei für zumindest eine Leistungsversorgung überprüft wird, ob eine geringere Anzahl oder Dauer von Gegenmaßnahmen als bei anderen Leistungsversorgungen durchgeführt wurde und bei Unterschreiten einer vorgegebenen Dauer oder Anzahl Maßnahmen zur Erhöhung der Dauer oder Anzahl durchgeführt werden.

2. Verfahren nach Anspruch 1, **dadurch gekennzeichnet, dass** für jede Leistungsversorgung eine Arcerkennung durchgeführt wird und ein mit der Arcerkennung in Beziehung stehendes Signal oder mit der Arcerkennung in Beziehung stehende Daten erzeugt werden.

3. Verfahren nach Anspruch 2, **dadurch gekennzeichnet, dass** das für eine Leistungsversorgung erzeugte mit der Arcerkennung in Beziehung stehende Signal und/oder die erzeugten mit der Arcerkennung in Beziehung stehende Daten den jeweils anderen Leistungsversorgungen und/oder der Plasmaprozessregelungseinrichtung übergeben werden.

4. Verfahren nach einem der vorhergehenden Ansprüche, **dadurch gekennzeichnet, dass** die Daten Informationen über die Anzahl und/oder Dauer von Umpolungen oder Aus-Zeiten der Leistungsversorgung umfassen.

5. Verfahren nach einem der vorhergehenden Ansprüche, **dadurch gekennzeichnet, dass** eine Gegenmaßnahme als Reaktion auf das Erkennen eines oder mehrerer Arcs eingeleitet wird.

6. Verfahren nach einem der vorhergehenden Ansprüche, **dadurch gekennzeichnet, dass** als mit der Arcerkennung in Beziehung stehende Daten Informationen über die von der Leistungsversorgung erzeugte Energie übermittelt wird.

7. Verfahren nach einem der vorhergehenden Ansprüche, **dadurch gekennzeichnet, dass** eine die Homogenität der Plasmabearbeitung begünstigende Maßnahme eingeleitet oder durchgeführt wird.

8. Verfahren nach Anspruch 7, **dadurch gekennzeichnet, dass** die die Homogenität der Plasmabearbeitung begünstigenden Maßnahmen umfassen:
• Einstellen der Arcerkennungsschwelle für eine oder mehrere Leistungsversorgungen;
• gezieltes periodisches oder aperiodisches Pulsen einer oder mehrerer Leistungsversorgungen;
• gezieltes Pulsen für einen eingeschränkten Zeitbereich;
• Hinzuziehen weiterer Kenngrößen zur Arcerkennung;
• Einstellung der Umpolspannung oder -dauer oder Aus-Zeit für eine oder mehrere Leistungsversorgungen;
• Verändern einer Blockierzeit;
• Verringerung der Gesamtleistung des Systems;
• Steuern der Leistung einzelner Leistungsversorgungen;
• Regeln der Vorschubgeschwindigkeit und/oder der Verweildauer der Substrate in der Plasmakammer.

9. Verfahren nach einem der vorhergehenden Ansprüche, **dadurch gekennzeichnet, dass** die Gegenmaßnahmen zumindest zweier Leistungsversorgungen synchronisiert werden.

10. Verfahren nach einem der vorhergehenden Ansprüche, **dadurch gekennzeichnet, dass** zumindest eine der Stromversorgungen gepulst betrieben wird.

11. Plasmasystem zur Durchführung des Verfahrens nach einem der vorhergehenden Ansprüche, mit zumindest zwei Leistungsversorgungen (20-23), einer Plasmakammer (10), einer Plasmaprozessregelungseinrichtung (30) und zumindest einer Arcerkennungseinrichtung, die einer der Leistungsversorgungen zugeordnet ist, wobei die Leistungsversorgungen signaltechnisch und/oder datentechnisch miteinander und/oder mit der Plasmaprozessregelungseinrichtung verbunden sind, **dadurch gekennzeichnet, dass** die Leistungsversorgungen eine Arcschnittstelleneinheit aufweisen, in der als mit der Arcerkennung in Beziehung stehende Daten Informationen über durchgeführte Gegenmaßnahmen generiert und von dieser ausgegeben werden.

12. Plasmasystem nach Anspruch 11, **dadurch gekennzeichnet, dass** die Leistungsversorgungen eine Eingangsvorrichtung (26-28), insbesondere umfassend einen Arc-Eingang, und/oder eine Ausgangsvorrichtung (26-28), insbesondere umfassend einen Arc-Ausgang, aufweisen.

13. Plasmasystem nach einem der vorhergehenden Ansprüche 11 oder 12, **dadurch gekennzeichnet, dass** ein Tor der Leistungsversorgungen als Eingangs- und Ausgangsvorrichtung ausgebildet ist.

14. Plasmasystem nach Anspruch 13, **dadurch gekennzeichnet, dass** das Ein-/Ausgangstor als Open-Kollektoranschluss ausgebildet ist und die Open-Kollektoranschlüsse der Leistungsversorgungen miteinander verbunden sind.

## Claims

1. Method for operating one or more plasma processes in a plasma chamber, with at least two power supplies and comprising the following method steps:
a. carrying out an arc detection for at least one of the power supplies;
b. generating at least one signal relating to the arc detection and/or data relating to the arc detection;
c. transferring the at least one signal and/or the data to a plasma process-regulating device and/or to one or more other power supplies or to one or more arc diverter devices associated with the other power supplies,
**characterised in that** as data relating to the arc detection, information about counter-measures implemented is transferred, wherein for at least one power supply a check is run to determine whether a lower number or duration of counter-measures than with other power supplies has been carried out and when a pre-defined duration or number is fallen below, measures to increase the duration or number are carried out.

2. A method according to claim 1, **characterised in that** an arc detection is carried out for each power supply and a signal relating to the arc detection or data relating to the arc detection is generated.

3. A method according to claim 2, **characterised in that** the signal relating to the arc detection generated for a power supply and/or the generated data relating to the arc detection is/are transferred to the respective other power supplies and/or to the plasma process-regulating device.

4. A method according to any one of the preceding claims, **characterised in that** the data comprises information about the number and/or duration of polarity reversals or OFF-times of the power supply.

5. A method according to any one of the preceding claims, **characterised in that** a counter-measure is initiated as response to the detection of one or more arcs.

6. A method according to any one of the preceding claims, **characterised in that** as data relating to the arc detection, information about the energy generated by the power supply is transferred.

7. A method according to any one of the preceding claims, **characterised in that** a measure promoting the homogeneity of the plasma processing is initiated or implemented.

8. A method according to claim 7, **characterised in that** the measures promoting the homogeneity of the plasma process include:
• setting the arc detection threshold for one or more power supplies;
• specific periodic or aperiodic pulsing of one or more power supplies;
• specific pulsing for a limited period;
• inclusion of further characteristic values for arc detection;
• setting the polarity reversing voltage or duration or OFF time for one or more power supplies;
• changing a blocking time;
• reducing the overall power of the system;
• controlling the power of individual power supplies;
• regulating the feed rate and/or the dwell time of the substrates in the plasma chamber.

9. A method according to any one of the preceding claims, **characterised in that** the counter-measures of at least two power supplies are synchronised.

10. A method according to any one of the preceding claims, **characterised in that** at least one of the power supplies is operated in pulse mode.

11. A plasma system for implementing the method according to any one of the preceding claims, having at least two power supplies (20-23), a plasma chamber (10), a plasma process-regulating device (30), and at least one arc detection device, which is assigned to one of the power supplies, the power supplies being connected via a signal link and/or data link to one another and/or to the plasma process-regulating device, **characterised in that** the power supplies have an arc interface unit, in which, as data relating to the arc detection, information about counter-measures implemented is generated and is output therefrom.

12. A plasma system according to claim 11, **characterised in that** the power supplies comprise an input device (26-28), in particular including an arc input, and/or an output device (26-28), in particular including an arc output.

13. A plasma system according to one of the preceding claims 11 or 12, **characterised in that** a port of the power supplies is in the form of an input and output device.

14. A plasma system according to claim 13, **characterised in that** the input/output port is in the form of an open-collector connection and the open collector connections of the power supplies are interconnected.

## Revendications

1. Procédé pour faire fonctionner un ou plusieurs procédés au plasma dans une chambre à plasma, avec au moins deux alimentations électriques, comprenant les étapes suivantes :
a. exécution d'une détection d'arc pour au moins une des alimentations électriques ;
b. production d'au moins un signal en relation avec la détection d'arc et/ou de données en relation avec la détection d'arc ;
c. transmission du ou des signaux et/ou des données à un dispositif de régulation de procédé au plasma et/ou à une ou plusieurs autres alimentations électriques ou à un ou plusieurs autres dispositifs de suppression d'arc associés aux autres alimentations électriques,
**caractérisé en ce que** des informations sur des contre-mesures exécutées sont transmises en tant que données en relation avec la détection d'arc, en vérifiant pour au moins une alimentation électrique s'il a été exécuté un nombre ou une durée plus faible de contre-mesures que pour les autres alimentations électriques et, si ce nombre est inférieur à une durée ou un nombre prédéfini(e), des mesures sont exécutées pour augmenter la durée ou le nombre.

2. Procédé selon la revendication 1, **caractérisé en ce qu'**une détection d'arc est exécutée pour chaque alimentation électrique et un signal en relation avec la détection d'arc et/ou des données en relation avec la détection d'arc sont produits.

3. Procédé selon la revendication 2, **caractérisé en ce que** le signal en relation avec la détection d'arc produit et/ou les données en relation avec la détection d'arc produites pour une alimentation électrique sont transmis aux autres alimentations électriques respectives et/ou au dispositif de régulation de procédé au plasma.

4. Procédé selon une des revendications précédentes, **caractérisé en ce que** les données comprennent des informations sur le nombre et/ou la durée d'inversions de polarité ou de périodes d'arrêt de l'alimentation électrique.

5. Procédé selon une des revendications précédentes, **caractérisé en ce qu'**une contre-mesure est déclenchée en réaction à la détection d'un ou plusieurs arcs.

6. Procédé selon une des revendications précédentes, **caractérisé en ce que** des informations sur l'énergie produite par l'alimentation électrique sont transmises en tant que données en relation avec la détection d'arc.

7. Procédé selon une des revendications précédentes, **caractérisé en ce qu'**une mesure favorisant l'homogénéité du traitement par plasma est déclenchée ou exécutée.

8. Procédé selon la revendication 7, **caractérisé en ce que** les mesures favorisant l'homogénéité du traitement par plasma comprennent :
- réglage du seuil de détection d'arc pour une ou plusieurs alimentations électriques ;
- pulsation périodique ou apériodique ciblée d'une ou plusieurs alimentations électriques ;
- pulsation ciblée pour une plage de temps limitée ;
- utilisation d'autres grandeurs caractéristiques pour la détection d'arc ;
- réglage de la tension ou de la durée d'inversion de polarité ou de la période d'arrêt pour une ou plusieurs alimentations électriques ;
- modification d'une durée de blocage ;
- diminution de la puissance totale du système ;
- commande de la puissance de certaines alimentations électriques ;
- régulation de la vitesse d'avance et/ou de la durée de séjour des substrats dans la chambre à plasma.

9. Procédé selon une des revendications précédentes, **caractérisé en ce que** les contre-mesures d'au moins deux alimentations électriques sont synchronisées.

10. Procédé selon une des revendications précédentes, **caractérisé en ce qu'**au moins une des alimentations électriques fonctionne en régime pulsé.

11. Système au plasma pour réaliser le procédé selon une des revendications précédentes, avec au moins deux alimentations électriques (20-23), une chambre à plasma (10), un dispositif de régulation de procédé au plasma (30) et au moins un dispositif de détection d'arc qui est associé à une des alimentations électriques, les alimentations électriques étant reliées entre elles et/ou au dispositif de régulation de procédé au plasma par technique de signalisation et/ou par technique informatique, **caractérisé en ce que** les alimentations électriques présentent une unité d'interface d'arc dans laquelle sont générées, puis délivrées par celle-ci, en tant que données en relation avec la détection d'arc, des informations sur des contre-mesures exécutées.

12. Système au plasma selon la revendication 11, **caractérisé en ce que** les alimentations électriques présentent un dispositif d'entrée (26-28), en particulier comprenant une entrée d'arc, et/ou un dispositif de sortie (26-28), en particulier comprenant une sortie d'arc.

13. Système au plasma selon une des revendications précédentes 11 ou 12, **caractérisé en ce qu'**une porte des alimentations électriques est réalisée sous la forme d'un dispositif d'entrée et de sortie.

14. Système au plasma selon la revendication 13, **caractérisé en ce que** la porte d'entrée et de sortie est réalisée sous la forme d'un circuit à collecteur ouvert et les circuits à collecteur ouvert des alimentations électriques sont reliés entre eux.
